# EUROPEAN PATENT APPLICATION

(11) **EP 1 562 121 A2**
(43) Date of publication of application: **10.08.2005**
(21) Application number: 05250382.8
(22) Date of filing: 26.01.2005
(51) Int. Cl.: G06F 12/02, G06F 12/08

(54) **Data management apparatus and method used for flash memory**

(30) Priority: 03.02.2004 KR 2004007002
(71) Applicant: Samsung Electronics Co., Ltd., Suwon-si, Gyeonggi-do (KR)
(72) Inventor: Myoung, Sung-ju, Yongin-si, Gyeonggi-do (KR); Kim, Jin-hyuk, Youngsan-gu, Seoul (KR); Cheong, Jae-wook, Gangdong-gu, Seoul (KR); Chung, Hyun-mo, Yongin-si, Gyeonggi-do (KR); Chung, Tae-sun, Seoul (KR)
(74) Representative: Robinson, Ian Michael

(57) **Abstract**

A data management apparatus and method used for a flash memory (100) are provided. The data management apparatus and method can prevent waste of memory space and deterioration of the performance of a flash memory caused by a difference between logical and physical operation units of the flash memory. The data management apparatus copies data stored in a physical block to which a data operation is to be performed to the internal memory (110), performs the data operation on the internal memory (110), and transfers the data to the physical block.

## Description

The present invention relates to a data management apparatus and method used for a flash memory, and more particularly, to a data management apparatus and method used for a flash memory, which can prevent waste of memory space and deterioration of the performance of a large block flash memory caused by a difference between a logical operation unit and a physical operation unit of the large block flash memory.

In general, home appliances, communications devices, and embedded systems, such as set-top boxes, use non-volatile memories as storage devices for storing and processing data.

Flash memories are one type of non-volatile memory, in which data can be electrically erased and overwritten. Flash memories are suitable for portable devices because they consume less power than magnetic disc memory-based storage mediums, are as accessible as hard discs, and are compact-sized.

Due to the hardware characteristics of flash memories, data recorded on a flash memory is erased in units of blocks, unlike in the conventional random access memory (RAM), nonvolatile storage medium or magnetic storage medium.

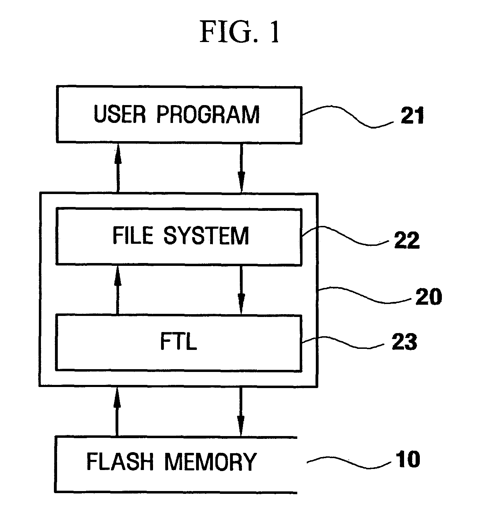

Figure 1 is a block diagram of such a typical flash memory system. Referring to Figure 1, the typical flash memory system includes a flash memory 10 and a controller 20. The controller 20 having a user program 21 loaded therein controls a predetermined data operation to be performed on the flash memory 10 at a user's request.

The controller 20 includes a file system 22, in which the user program 21 is loaded, and a flash translation layer (FTL) 23, which transfers the predetermined data operation requested by the user, such as a read or write operation, to the flash memory 10.

The FTL 23 is software that helps use the flash memory 10 as a block device, and generally supports a block re-mapping method for managing the flash memory 10.

Here, the block re-mapping method enables management of mapping information on the relationships between logical block numbers (LBNs) and physical block numbers (PBNs) of given data. By doing so, data recorded in the flash memory 10 is always accessible with the same logical block number (LBN) even though a pertinent PBN changes. In fact, the PBN recorded in the flash memory 10 may change when the data stored in the flash memory 10 is modified or erased from the flash memory 10.

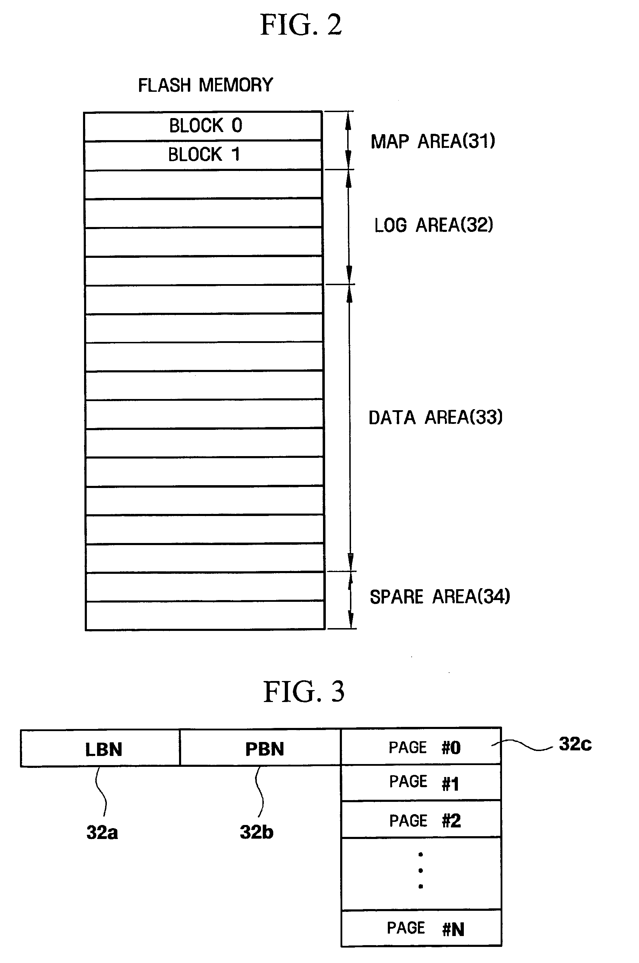

A low level format operation should be performed on the flash memory 10 by the FTL 23 in order to make the flash memory 10 usable. Referring to Figure 2, the flash memory 10 that has undergone the low level format operation is divided into a map area 31, a log area 32, a data area 33, and a spare area 34.

Each of the map area 31, the log area 32, the data area 33, and the spare area 34 is comprised of at least one block.

The map area 31 includes a block mapping table, which converts an LBN into a PBN. Specifically, the block mapping table maps an LBN to a PBN of a block (hereinafter referred to as a data block) of the data area 33. If the block mapping table is updated, the updated block mapping table is stored in a block (hereinafter referred to as map block) of the map area 31.

In addition, when a predetermined data operation, such as a read or write operation, is performed on the flash memory 10 at a user's request, the log area 32 is used ahead of the data area 33.

A log table maps an LBN that has been used by the user to issue a request for performing the predetermined data operation on the flash memory 10 to a PBN of a block (hereinafter referred to as a log block) in the log area 32. The log table is stored in the log area 32.

Referring to Figure 3, the log table includes a LBN 32a, a PBN 32b, which designates a predetermined log block and is mapped to the LBN 32a, and page numbers 32c, which designate pages of the predetermined log block where data exists.

A block of the flash memory 10 is comprised of a plurality of pages in which a data operation is performed on the flash memory 10.

When writing data to the log area 32, the data are written to any vacant pages in the log area 32. The page numbers 32c specify pages to which the data should have been written.

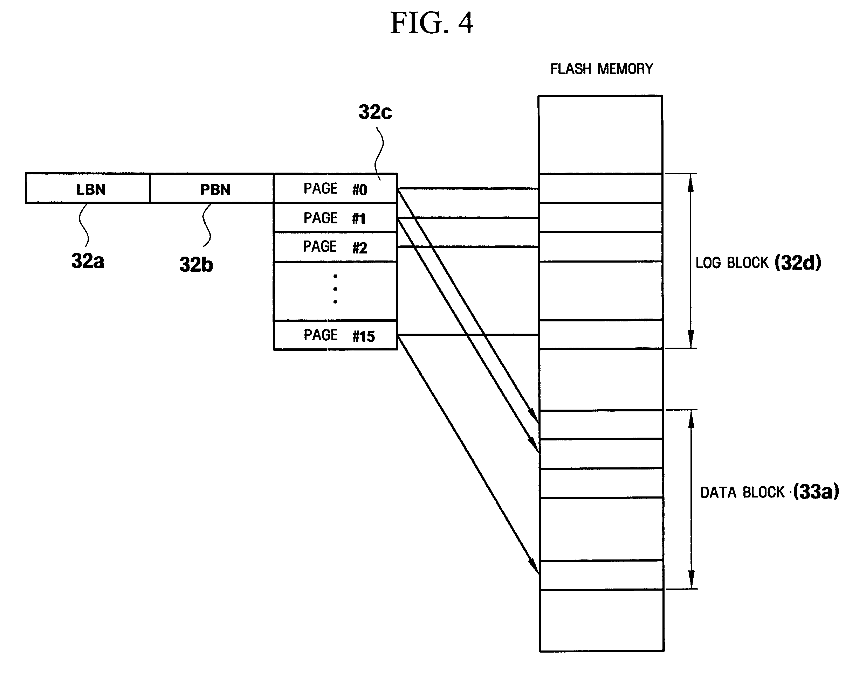

Therefore, the page numbers 32c enable data stored in pages of a log block 32d of the log area 32 to be transferred to the respective pages of a data block 33a of the data area 33, as shown in Figure 4.

The FTL 23 divides the data area 33 into a plurality of data blocks having a predetermined size. Thus, the data area 33 is accessed in units of data blocks. PBNs are sequentially allocated to the data blocks.

The spare area 34 is used when no memory space is left in the log area 32 so that data cannot be written to the log area 32 any longer.

A data operation performed on the flash memory 10 will now be described in further detail.

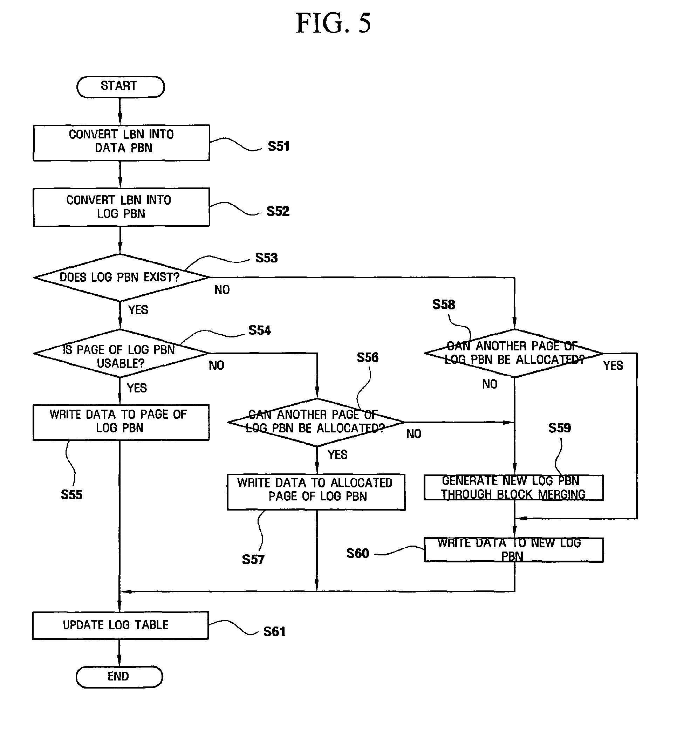

Figure 5 is a flowchart of a conventional method of writing data to a flash memory. Referring to Figure 5, in operation S51, an LBN is converted into a PBN (hereinafter referred to as a data PBN of the data area 33 with reference to a block mapping table stored in the map area 31.

In operation S52, the LBN is also converted into a PBN (hereinafter referred to as a log PBN) of the log area 32 with reference to a log table stored in the log area 32.

If a log PBN that matches with the LBN exists in operation S53 and a page of a log block designated by the log PBN is empty in operation S54, data is written to the page of the log block in operation S55.

If the page of the log block is already filled with other data, it is determined whether another page of the log block can be allocated in operation S56.

In operation S57, if another page of the log block can be allocated, data is written to the corresponding page of the log block.

In operation S58, if the log block designated by the log PBN is determined to have already been filled with data, it is determined whether another log block can be allocated.

In operation S59, if no log block can be allocated, a new log block is generated through block merging.

In operation S60, data is written to the new log block.

In operation S61, if another log block can be allocated, data is written to the corresponding log block.

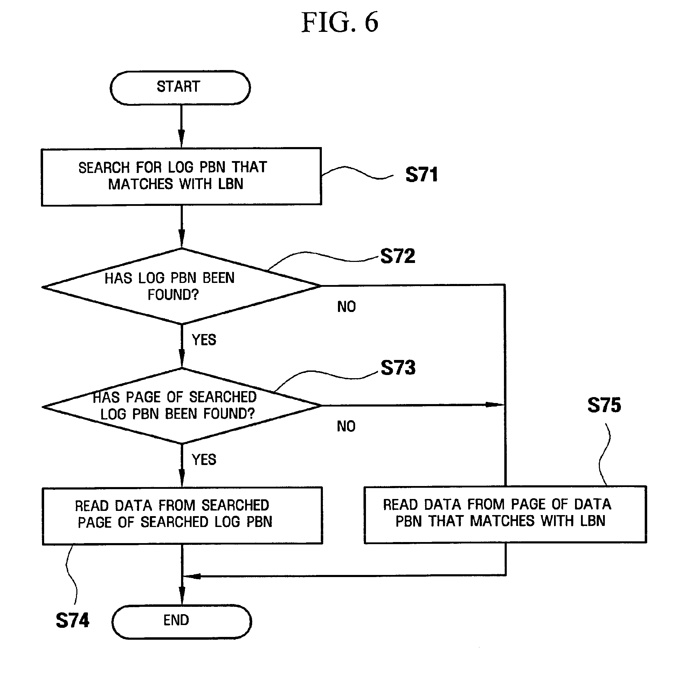

Alternatively, in order to read data from a flash memory, as shown in Figure 6, in operation S71, a log PBN that matches with an LBN used by a user is searched for.

If the log PBN that matches with the LBN exists in operation S72, a page where data is written is searched for by accessing the log PBN that matches with the LBN in operation S73.

In operation S74, if data exists in the searched page, the data is read from the searched page.

In operation S75, if the log PBN that matches with the LBN does not exist or if no page where data is written is found at the log PBN that matches with the LBN, data is searched for and read from a data block designated by a data PBN that is determined to match with the LBN with reference to a block mapping table.

A flash memory is classified into a small-block flash memory or a large-block flash memory.

In a small-block flash memory, a logical operation unit is identical to a physical operation unit, while in a large-block flash memory, a physical operation unit is larger than a logical operation unit.

Specifically, in a large-block flash memory, a physical operation unit is comprised of at least one logical operation unit.

Thus, a considerable amount of the storage capacity of the large-block flash memory may be wasted due to such difference between the logical and physical operation units of the large-block flash memory.

For example, suppose that logical operations are performed on the large-block flash memory in units of 512 bytes and physical operations are performed on the large-block flash memory in units of 2048 bytes. If a user performs a data operation on the large-block flash memory in units of 512 bytes, only 512 bytes of each block of the large-block flash memory is used, and the remaining 1536 bytes of each block of the large-block flash memory, which accounts for 75% of the storage capacity of the large-block flash memory, is wasted.

An aim of the present invention is to provide a data management apparatus and method used for a flash memory, which can prevent waste of memory space caused by a difference between a logical operation unit and a physical operation unit of the large block flash memory.

According to the present invention there is provided an apparatus and method as set forth in the appended claims. Preferred features of the invention will be apparent from the dependent claims, and the description which follows.

According to an aspect of the present invention, there is provided a data management apparatus used for a flash memory having an internal memory. The data management apparatus copies data stored in a physical block to which a data operation is to be performed to the internal memory, performs the data operation on the internal memory, and transfers the data to the physical block.

Preferably, but not necessarily, data corresponding to physical operation units of the flash memory is copied to the internal memory.

The data copied from the physical block to the internal memory is preferably, but not necessarily, modified in logical operation units of the flash memory.

According to another aspect of the present invention, there is provided a data management method used for a flash memory having an internal memory, comprising copying data stored in a physical block, to which a data operation is to be performed, to the internal memory, and performing the data operation on the internal memory.

The copying of the data stored in the physical block to internal memory may comprise searching for a physical block corresponding to a logical block to which the data operation is to be performed, and copying data stored in the physical block to the internal memory in physical operation units of the flash memory.

The searching for the physical block may comprise searching for the physical block with reference to a table that maps a logical block number to a physical block number.

The copying of the data stored in the physical block may comprise performing data operations on the data coped from the internal memory in units of logical operation units.

The data management method may further comprise transferring the data on which data operations have been completed from the internal memory to the physical block.

The transferring of the data may comprise updating the table after the data is transferred to the physical block.

The above and other features and advantages of the present invention will become more apparent by describing in detail exemplary embodiments thereof with reference to the attached drawings in which:
Figure 1 is a block diagram of a conventional data management apparatus used for a flash memory;
Figure 2 is a diagram illustrating the structure of a flash memory that has been subjected to a low level format operation;
Figure 3 is a diagram illustrating a typical log table;
Figure 4 is a diagram illustrating the transfer of data from a log block to a data block with reference to the typical log table of Figure 3;
Figure 5 is a diagram illustrating a conventional method of writing data to a flash memory;
Figure 6 is a diagram illustrating a conventional method of reading data from a flash memory;
Figure 7A is a diagram illustrating a typical small-block flash memory;
Figure 7B is a diagram illustrating a typical large-block flash memory;
Figure 8 is a block diagram of a data management apparatus used for a flash memory, according to an exemplary embodiment of the present invention;
Figure 9 is a diagram illustrating the structure of a flash memory that has been subjected to a low-level format operation performed by a flash translation layer (FTL);
Figure 10 is a diagram illustrating a block mapping table according to an exemplary embodiment of the present invention;
Figure 11 is a diagram illustrating the mapping of blocks in a log area to blocks in a data area according to an exemplary embodiment of the present invention;
Figure 12 is a diagram illustrating a log table according to an exemplary embodiment of the present invention;
Figure 13A is a diagram illustrating a typical method of writing data to a single sector;
Figure 13B is a diagram illustrating a typical method of writing data to multiple sectors;
Figure 14 is a flowchart of a method of writing data to a flash memory according to an exemplary embodiment of the present invention;
Figure 15 is a diagram illustrating the writing of data to sectors of a flash memory, according to an exemplary embodiment of the present invention;
Figure 16 is a diagram illustrating the writing of data to a page of a log block, according to an exemplary embodiment of the present invention;
Figure 17 is a diagram illustrating the copying of data stored in a page of a data block to an internal memory, according to an exemplary embodiment of the present invention;
Figure 18 is a diagram illustrating the modification of data copied to an internal memory and the transfer of the modified data to a log block, according to an exemplary embodiment of the present invention; and
Figure 19 is a flowchart of a method of reading data from a flash memory according to an exemplary embodiment of the present invention.

Advantages and features of the present invention and methods of accomplishing the same may be understood more readily by reference to the following detailed description of preferred embodiments and the accompanying drawings. The present invention may, however, be embodied in many different forms and should not be construed as being limited to the embodiments set forth herein. Rather, these embodiments are provided so that this disclosure will be thorough and complete and will fully convey the concept of the invention to those skilled in the art, and the present invention will only be defined by the appended claims. Like reference numerals refer to like elements throughout the specification.

The present invention will now be described more fully with reference to the accompanying drawings in which exemplary embodiments of the invention are shown.

A flash memory is generally classified into a small-block flash memory and a large-block flash memory.

Whereas the small-block flash memory has a logical operation unit and a physical operation unit of the same size, the large-block flash memory has a physical operation unit having a size larger than that of a logical operation unit.

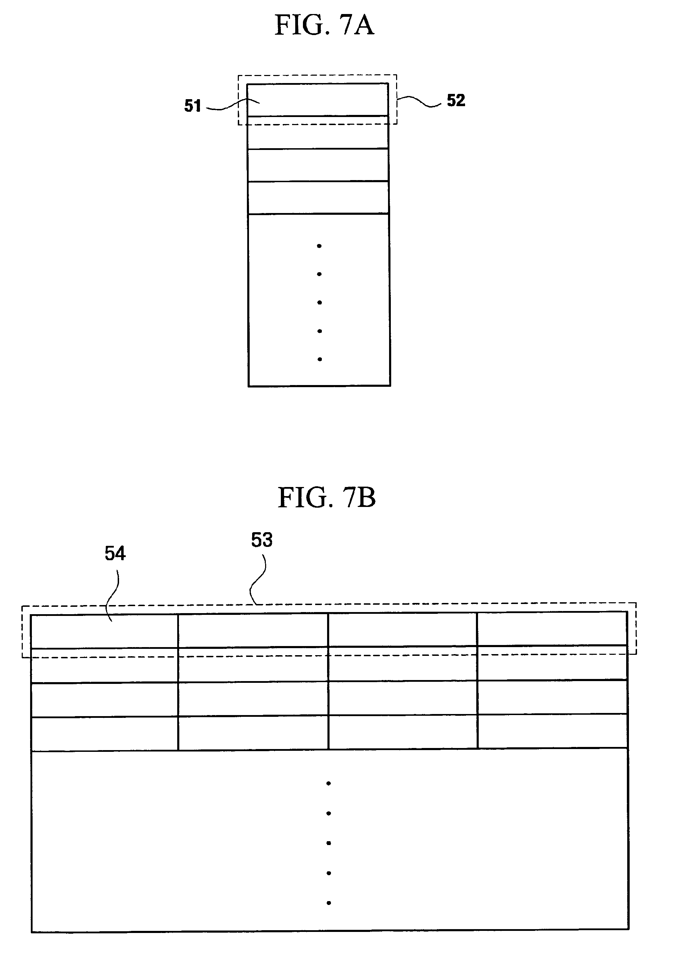

That is to say, in the small-block flash memory, a unit in which logical operations are performed on the small-block flash memory, i.e., a logical operation unit 51, is identical to a unit in which physical operations are performed on the small-block flash memory, i.e., a physical operation unit 52, as shown in Figure 7A.

On the other hand, in the large-block flash memory, a physical operation unit 53 includes at least one logical operation unit 54, as shown in Figure 7B.

Here, the logical operation units 51 and 54, which are data operation units used by a user, are generally called sectors, and the physical operation units 52 and 53, which are data operation units used in the respective flash memories, are generally called pages.

Sizes of the logical and physical operation units may vary according to the type of an apparatus employing the flash memory.

In such cases, data operations are more efficiently performed on a single-block flash memory than on a large-block flash memory because logical and physical operation units of a single-block flash memory are identical, while logical and physical operation units of a large-block flash memory are not identical.

For example, suppose that logical operations are performed on a large-block flash memory in units of 512 bytes and physical operations are performed on the large-block flash memory in units of 2048 bytes. If a user performs a data operation on the large-block flash memory in units of 512 bytes, only 512 bytes of each block of the large-block flash memory is used, and the remaining 1536 bytes of each block of the large-block flash memory is wasted.

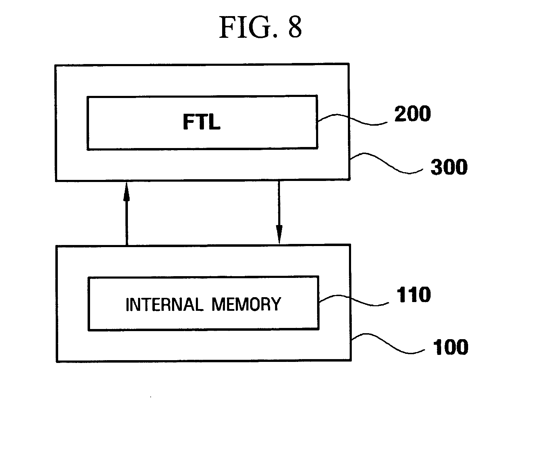

The present invention is directed to a data management apparatus used for a flash memory, which is capable of preventing waste of memory space and deterioration of the performance of a large-block flash memory caused by a difference between a logical operation unit and a physical operation unit of the large-block flash memory. The data management apparatus is shown in Figure 8. Referring to Figure 8, the data management apparatus includes a flash translation layer (FTL) 200, which enables a flash memory 100 including an internal memory 110 to be used as a block device and includes mapping information on the relationship between a logical block number (LBN) and a physical block number (PBN) of the flash memory 100, and a controller 300, which transfers data stored at a pertinent physical address to the internal memory 110 and allows a data operation to be performed on the internal memory 110.

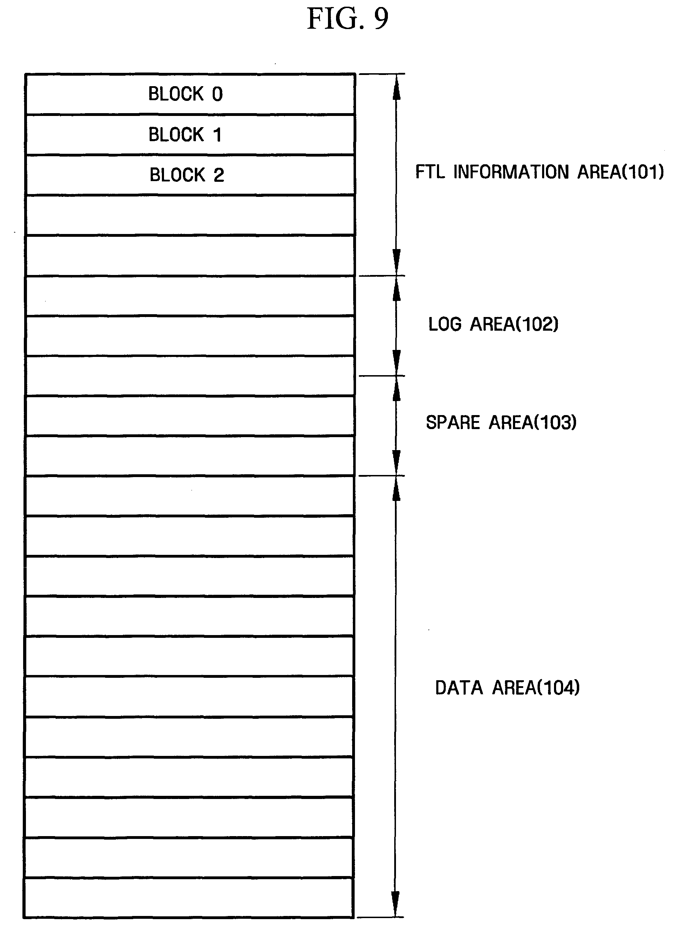

The FTL 200 performs a low level format operation on the flash memory 100 in order to make the flash memory 100 usable. As a result of the low level format operation, the flash memory 100 is divided into an FTL information area 101, a log area 102, a spare area 103, and a data area 104, as shown in Figure 9. Each of the FTL information area 101, the log area 102, the spare area 103, and the data area 104 is comprised of at least one block.

In this case, the FTL information area 101 includes a block mapping table that maps an LBN specified by the user to a data PBN.

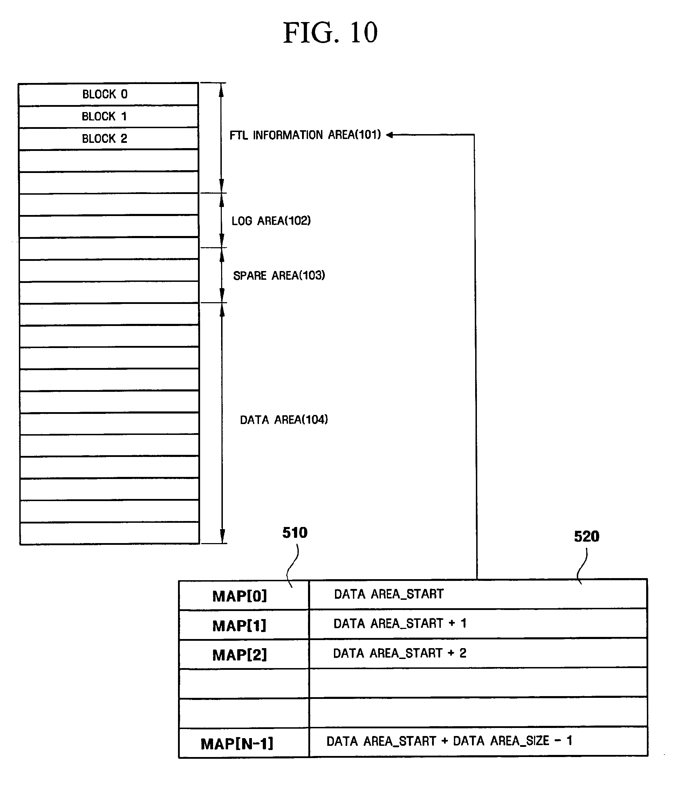

The block mapping table is illustrated in Figure 10. Referring to Figure 10, the block mapping table includes an LBN 510 specified by a user and a data PBN 520 corresponding to the LBN 510.

A log table that maps the LBN specified by the user to a log PBN is stored in the log area 102.

In other words, when performing a data operation on the flash memory 100, the data operation is performed on the log area 102 having the log table ahead of other areas of the flash memory 100.

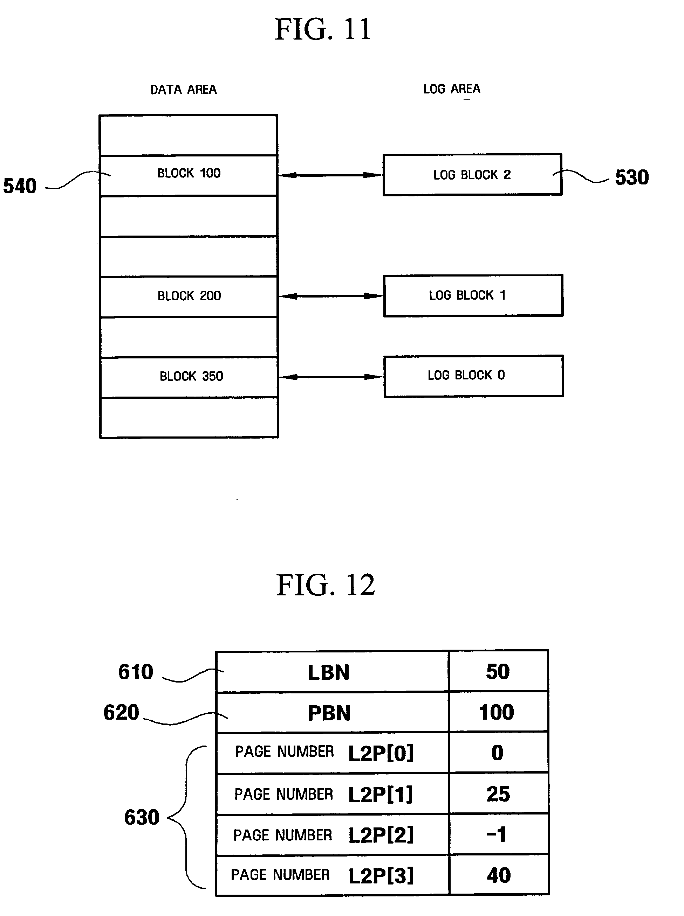

In addition, each log PBN of the log area 102 is mapped to a data PBN. Referring to Figure 11, a log PBN 530 is mapped to a data PBN 540.

Referring to Figure 12, the log table includes an LBN 610, a PBN 620, which is mapped to the LBN 610, and page numbers 630 included in the PBN 620.

The spare area 103 is used when no memory space is left in the log area 102 so that data cannot be written to the log area any longer.

In other words, if the log area 102 is full of data so that data operations cannot be performed on the log area 102 any longer, the LBN specified by the user is mapped to a PBN of the spare area 104, so data operations can be performed on the spare area 104 later on.

The controller 300 controls data stored at a PBN corresponding to the LBN specified by the user to be transferred to the internal memory 110 to perform a data operation on the internal memory 110.

Here, the LBN specified by the user specifies a corresponding PBN and information on logical and physical operation units included in a block designated by the corresponding PBN, i.e., information on sectors and pages in the block designated by the corresponding PBN.

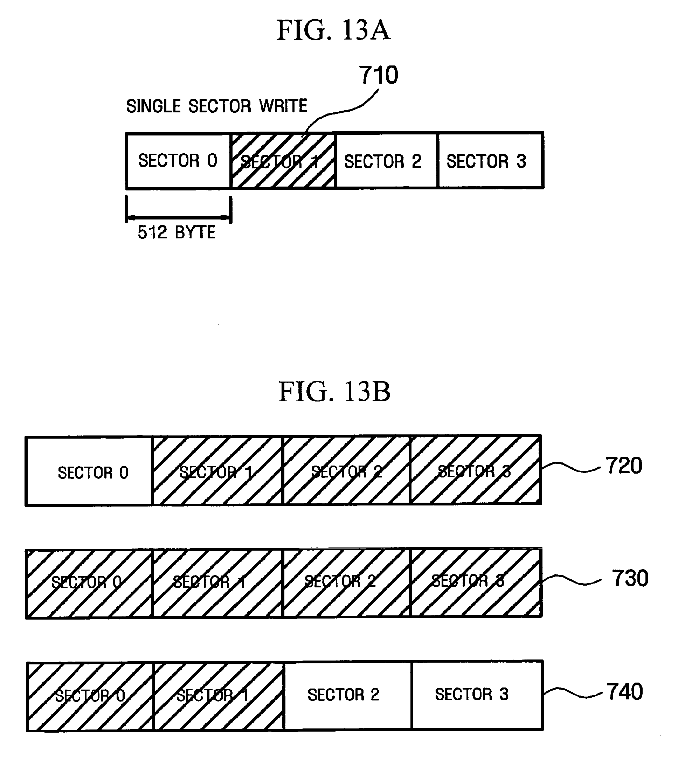

For example, suppose that a sector has a size of 512 bytes and a page has a size of 2048 bytes. Then, a data operation may be performed on a single sector of a predetermined page 710, as shown in Figure 13A. Meanwhile, the data operation may also be performed on one or more sectors of a predetermined page 720, 730, or 740, as shown in Figure 13B.

In other words, the controller 300 copies data prestored in a pertinent page of the flash memory 100 to a pertinent page of the internal memory 110, performs a data operation on one or more sectors of the pertinent page of the internal memory 110, and writes the data to the page of the flash memory 100.

In the present embodiment, a case where a physical address, in which the data operation is to be performed is occupied by predetermined data, that is, no empty space is available, will be described by way of example.

In this case, if the data of the pertinent page is copied to the internal memory 110 so that the data of sectors of the pertinent page may be overwritten, thereby preventing waste of memory space caused by a difference between the logical and physical operation units of the flash memory 100 is prevented.

The operation of the data management method used for a flash memory, according to the exemplary embodiment of the present invention, i.e., a data management method used for a flash memory, according to an exemplary embodiment of the present invention, will now be described.

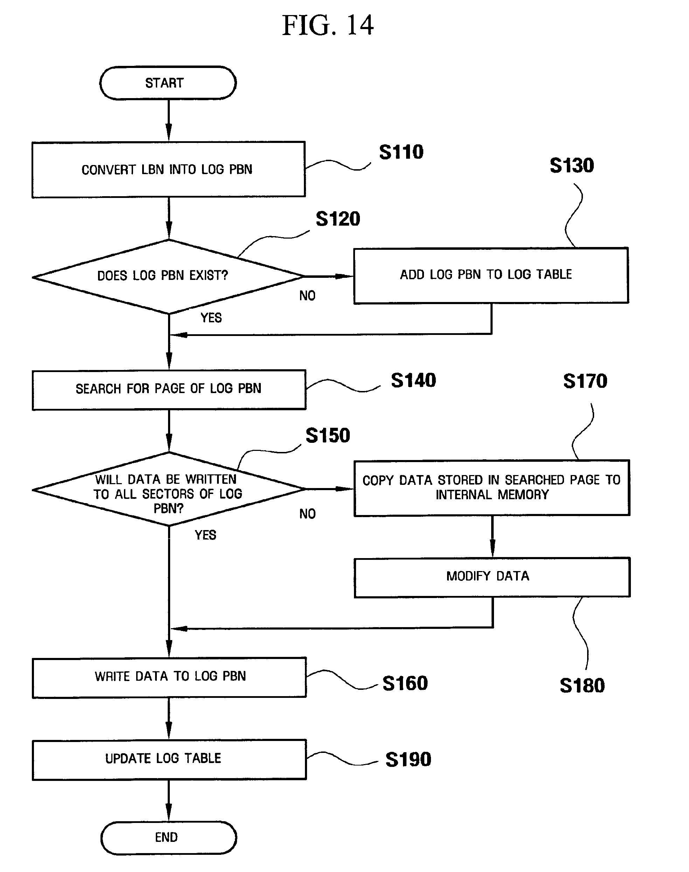

Figure 14 is a flowchart of a method of writing data to a flash memory according to an exemplary embodiment of the present invention. Referring to Figures 10 and 14, in operation S110, an LBN used by a user is converted into a log PBN with reference to a log table.

Here, since data is written to the log area 102 ahead of other areas of the flash memory 100, the LBN is converted into a log PBN.

If there is no log PBN that matches with the LBN in operation S120, a log PBN that matches with the LBN is added to the log table in operation S130.

Then, the data management method proceeds to operation S140.

Thereafter, if the log PBN that matches with the LBN exists in operation S120, a page of the corresponding log PBN is searched for in operation S140.

In operation S150, it is determined whether to write data to all of a plurality of sectors of the searched page.

In operation S160, if it is determined to write the data to all of the sectors of the searched page, the data is written to all of the sectors of the searched page.

If it is determined to write the data to some of the sectors of the searched page, the data is copied to the internal memory 110 in operation S170.

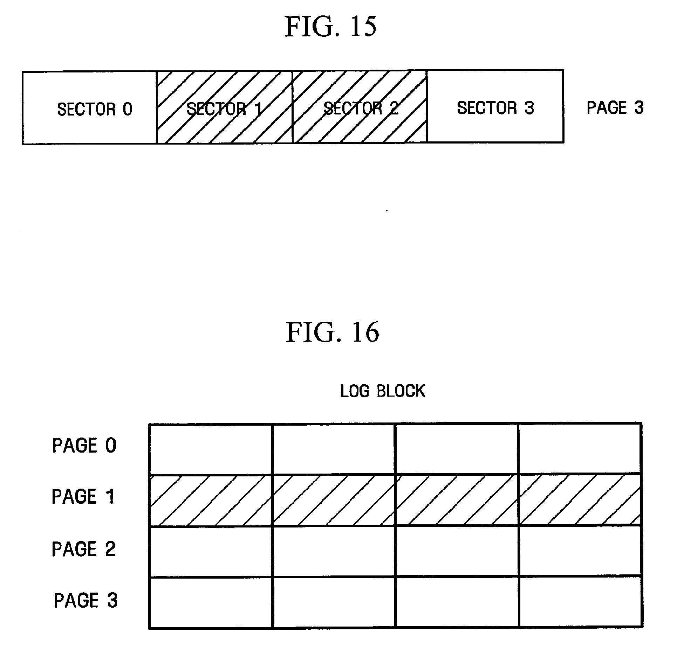

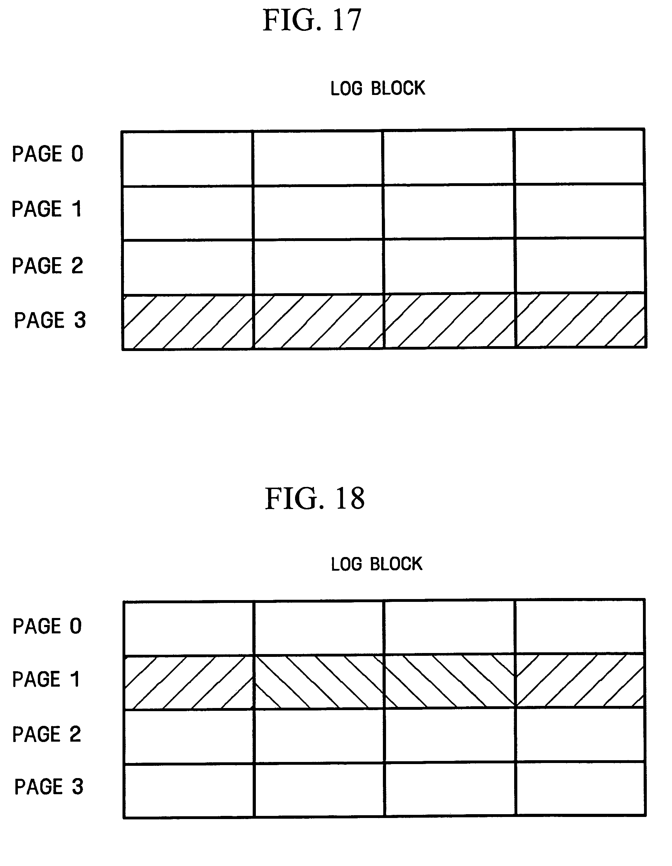

For example, in a case where data is written to sectors 1 and 2 of page 3 at a predetermined LBN, as shown in Figure 15, and is written to page 1 of a log block of Figure 16, designated by a log PBN corresponding to the predetermined LBN, data stored in page 3 of a data block of Figure 17, designated by a data PBN corresponding to the predetermined LBN, is copied to the internal memory 110.

Alternatively, the data written to page 1 of the log block of Figure 16, instead of the data stored in page 3 of the data block of Figure 17, may be copied to the internal memory 110.

In operation S180, the data copied to the internal memory 110 is modified and then written to its original location.

For example, referring to Figure 18, data stored in sectors 1 and 2 of page 3 of the data block of Figure 17 is copied to the internal memory 110 and then modified. The modified data is written to sectors 1 and 2 of page 1 of the log block of Figure 16.

In operation S190, if the writing of the data to the searched page is complete, the log table is updated.

A method of reading data from a flash memory according to another embodiment of the present invention will now be described.

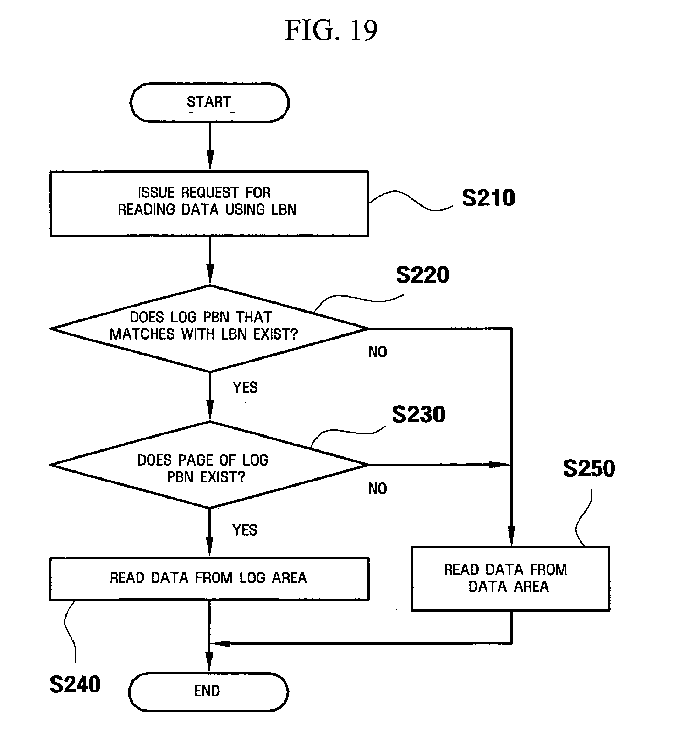

In the method of reading data from a flash memory shown in Figure 19, in operation S210, a user issues a request for reading data from the flash memory using a predetermined LBN.

In operation S220, it is determined whether a log PBN that matches with the predetermined LBN exists with reference to the log table stored in the FTL information area 101.

In operation S230, if the log PBN that matches with the predetermined LBN exists, it is determined whether data exists in a log block designated by the corresponding log PBN.

In operation S240, if data exists in the log block, data is read from a page of the log block.

In operation S250, if no data exists in the log block, data is read from a page of a data block designated by a data PBN that is determined to match with the predetermined LBN with reference to the log table.

As described above, the data management apparatus and method used for a flash memory according to the present invention have the following advantages.

First, it is possible to prevent waste of memory space of a large-block flash memory caused by a difference between logical and physical operation units of the large-block flash memory.

Second, it is possible to enhance the performance of a flash memory through the efficient use of the storage capacity of the flash memory.

Although a few preferred embodiments have been shown and described, it will be appreciated by those skilled in the art that various changes and modifications might be made without departing from the scope of the invention, as defined in the appended claims.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A data management apparatus used for a flash memory (100) having an internal memory (110), comprising a controller (300) configured to perform a control operation such that data stored in a physical block (53) to which a data operation is to be performed is copied to the internal memory (110), the data operation is performed on the internal memory (110), and the data on which the data operation has been performed is transferred to the physical block (53).

2. The data management apparatus of claim 1, wherein data corresponding to physical operation units (53) of the flash memory (100) is copied to the internal memory (110).

3. The data management apparatus of claim 2, wherein the data copied from the physical block (53) to the internal memory (110) is modified in logical operation units (54) of the flash memory (100).

4. A data management method used for a flash memory (100) having an internal memory (110), comprising:
copying data stored in a physical block (53), to which a data operation is to be performed, to the internal memory (110); and
performing the data operation on the internal memory (110).

5. The data management method of claim 4, wherein the copying of the data stored in the physical block (53) to internal memory (110), comprises:
searching for a physical block (53) corresponding to a logical block (54) to which the data operation is to be performed; and
copying data stored in the physical block (53) to the internal memory (110) in physical operation units (53) of the flash memory (100).

6. The data management method of claim 5, wherein the searching for the physical block (53) comprises searching for the physical block (53) with reference to a table that maps a logical block (54) number to a physical block (53) number.

7. The data management method of claim 6, wherein the copying of the data stored in the physical block (53) comprises performing data operations on the data copied from the internal memory (110) in units of logical operation units (54).

8. The data management method of claim 7, further comprising transferring the data on which data operations have been completed from the internal memory (110) to the physical block (53).

9. The data management method of claim 8, wherein the transferring of the data comprises updating the table after the data is transferred to the physical block (53).
